# FASCICULE DE BREVET EUROPEEN

(11) **EP 1 860 707 B1**
(45) Date de publication et mention de la délivrance du brevet: **04.05.2011**
(21) Numéro de dépôt: 07290621.7
(22) Date de dépôt: 15.05.2007
(51) Int. Cl.: H01L 33/00, F21S 8/10

(54) **Composant de dissipation thermique et dispositif d'éclairage et/ou de signalisation à diode équipé d'un tel composant**
Wärmeableitunseinrichtung und LED Beleuchtungs- und/oder Signalvorrichtung mit einer solchen Einrichtung
Heat dissipation component and LED lighting and/or signalling device comprising said component

(30) Priorité: 22.05.2006 FR 0604575
(43) Date de publication de la demande: 28.11.2007
(73) Titulaire: VALEO VISION, 93012 Bobigny Cedex (FR)
(72) Inventeur: Gasquet, Jean-Claude, 89100 Saint Clement (FR); Tanghe, Alcina, 78760 Jouars Pontchartrin (FR)

(56) Documents cités:
- EP-A- 1 139 019
- EP-A- 1 439 587
- EP-A- 1 544 924
- US-A- 5 357 536

## Description

L'invention concerne un composant de dissipation thermique pour une diode électroluminescente.

Elle concerne aussi un dispositif d'éclairage et/ou de signalisation équipé d'un composant de dissipation thermique et un procédé de fabrication d'un tel dispositif.

Le domaine technique de l'invention est, d'une façon générale, celui des projecteurs, des composants de signalisation ou d'éclairage pour les véhicules automobiles, comportant au moins une diode électroluminescente, notamment une diode électroluminescente dite "de puissance".

Dans l'état de la technique, on a déjà proposé d'utiliser la diode électroluminescente en raison des nombreux avantages qu'elle présente.

En effet, la diode consomme moins d'énergie électrique, même à intensité de flux lumineux égale, qu'une lampe à décharge ou à incandescence qui sont traditionnellement utilisées dans le domaine de l'automobile.

La diode ne rayonne pas de façon omnidirectionnelle, mais rayonne de manière plus directive que la lampe à décharge. Ainsi, la quantité de lumière perdue, et donc d'énergie électrique, est plus faible.

Cependant, au cours de son fonctionnement, la diode produit de la chaleur. L'échauffement de la diode est préjudiciable à son bon fonctionnement, car plus la diode monte en température, plus son flux lumineux diminue.

Pour abaisser sa température de fonctionnement, la diode comporte une embase métallique de dissipation thermique, souvent appelée "slug", permettant d'établir un contact thermique avec un dissipateur thermique, comme un radiateur, pour dissiper la chaleur produite par la diode.

On connaît de nombreux composants permettant de dissiper la chaleur d'une diode électroluminescente.

Le document EP-A-1.463.391 du demandeur concerne un procédé et un composant du même genre. Mais, le mode de fixation de l'embase de la diode sur le dissipateur thermique est nécessairement exécuté par un procédé de soudage coûteux, la soudure laser par points.

La présente invention vise notamment à fournir une solution autorisant le recours à d'autres procédés de fixation comme une soudure par fusion dans un four, malgré la fragilité de composants comme la diode électroluminescente.

Le document EP-A-1.139.019 décrit un composant de dissipation de chaleur associé à une diode électroluminescente de puissance dont chacune des deux pattes de connexion électrique est raccordée électriquement à une piste d'une plaque à circuits imprimés.

La plaque à circuits imprimés s'étend au dessus d'un dissipateur thermique en cuivre en formant un vide entre la plaque à circuits imprimés et le dissipateur thermique.

La plaque à circuits imprimés comporte un trou de passage dans lequel la diode est agencée, de sorte que l'embase de dissipation thermique de la diode établisse un contact thermique avec le dissipateur thermique en cuivre.

Un agent de conduction thermique est disposé entre l'embase de dissipation thermique de la diode et le dissipateur thermique, pour améliorer la conduction thermique entre l'embase de la diode et le dissipateur thermique.

Un tel dissipateur permet d'évacuer efficacement la chaleur produite par la diode, mais ne permet pas une orientation précise de la diode.

En effet, l'embase de la diode est disposée sur un agent de conduction thermique du type graisse thermique, pâte thermique, colle thermique, qui n'est donc pas solide. Par conséquent, l'agent de conduction thermique utilisé n'est pas une surface de référence permettant d'orienter la diode de façon précise.

De même, les pattes de fixation de la diode qui fixent la diode sur la plaque à circuits imprimés ne sont pas une bonne référence de mise en position compte tenu, notamment, de leur flexibilité.

Or, dans le cas d'un dispositif d'éclairage et/ou de signalisation, la position relative du faisceau de lumière émis par la diode par rapport à un élément optique, comme un réflecteur de lumière et/ou une lentille, doit être précise si l'on veut obtenir un rendement optimum du dispositif d'éclairage et/ou de signalisation.

De plus, la conception du composant de dissipation décrit dans le document EP-A-1.139.019 ne permet pas d'utiliser une plaque souple à circuits imprimés, dite "flexboard", étant donné que la diode est fixée sur la plaque à circuits imprimés et qu'un vide sépare la plaque à circuits imprimés du dissipateur thermique. Cet aspect est un inconvénient, notamment si on veut disposer la plaque à circuits imprimés dans différents plans.

Le document EP 1439587 A1 montre un composant d'après le préambule de la revendication 1.

L'invention propose un composant de dissipation thermique permettant d'établir un contact thermique entre l'embase d'une diode et un dissipateur thermique, pour dissiper la chaleur produite par la diode tout en assurant une orientation précise de la diode.

A cet effet, l'invention propose un composant de dissipation thermique pour dispositif d'éclairage et/ou de signalisation de véhicule du type comportant :
- une plaque à circuits imprimés isolante électriquement comportant au moins deux pistes conductrices d'électricité,
- au moins une diode électroluminescente qui comporte une embase de dissipation thermique et une paire de pattes de connexion électrique, chaque patte de connexion devant être raccordée électriquement à une piste conductrice de la plaque à circuits imprimés,
- un dissipateur thermique qui s'étend en vis-à-vis de la plaque à circuits imprimés,
tel que le dissipateur thermique comporte au moins une portion d'échange thermique apte à être couplée à une face d'échange thermique de l'embase d'au moins une diode associée et en ce que ladite portion d'échange thermique du dissipateur thermique comporte des moyens d'orientation d'au moins une diode associée qui font saillie au niveau de portion d'échange thermique du dissipateur, la face d'échange thermique de l'embase de chaque diode étant destinée à être posée sur lesdits moyens d'orientation, notamment de manière qu'une direction de référence de chaque diode soit orientée par rapport à un plan de référence du dissipateur.

Selon d'autres caractéristiques du composant de dissipation thermique :
- les moyens d'orientation font saillie substantiellement perpendiculairement à la portion d'échange thermique du dissipateur,
- les moyens d'orientation comportent une pluralité de plots qui font saillie perpendiculairement à la portion d'échange thermique selon des dimensions permettant de déterminer la direction de référence de chaque diode,
- les moyens d'orientation comportent au moins deux nervures qui font saillie perpendiculairement à la portion d'échange thermique,
- le dissipateur thermique comporte un bossage sur lequel est agencé la portion d'échange thermique du dissipateur,
- le composant de dissipation thermique comporte un apport de matière qui est disposé entre la portion d'échange thermique du dissipateur thermique et la face d'échange thermique de l'embase de chaque diode associée, afin de fixer la portion d'échange thermique avec l'embase de chaque diode et/ou de former un joint thermique entre la portion d'échange thermique et l'embase de chaque diode,
- le dissipateur thermique comporte des moyens de centrage de chaque diode associée par rapport au plan de référence du dissipateur,
- le dissipateur thermique comporte des moyens de fixation avec la plaque à circuits imprimés,
- le dissipateur thermique est en matériau qui est apte à subir une déformation plastique, comme un matériau ductile,
- le dissipateur thermique est en cuivre ou en alliage de cuivre d'une épaisseur déterminée en fonction de caractéristiques de conduction thermique déterminées,
- la plaque à circuits imprimés comporte au moins un trou à travers lequel s'étend au moins une diode et/ou la portion d'échange thermique du dissipateur,
- la plaque à circuits imprimés est souple et est apte à être maintenue sur le dissipateur par des moyens de fixation.

L'invention concerne aussi un dispositif de signalisation et/ou d'éclairage du type comportant au moins un composant de dissipation thermique et un support qui est fixé sur le composant de dissipation thermique au moyen de pions de fixation, les pions de fixation étant fixés dans des ouvertures associées du dissipateur thermique.

Selon d'autres caractéristiques du dispositif de signalisation et/ou d'éclairage :
- le dispositif de signalisation et/ou d'éclairage comporte un élément optique comme un filtre, et/ou une lentille et/ou un réflecteur qui est disposé sur la plaque à circuits imprimés et qui est fixé sur le dissipateur thermique au moyen de pions de fixation, les pions de fixation traversant la plaque à circuits imprimés et étant fixés dans des ouvertures associées du dissipateur thermique,
- le composant comporte un dissipateur unique qui comporte une pluralité de portions d'échange thermique, les portions d'échange thermique étant chacune agencées dans un plan différent, chaque portion d'échange thermique comportant au moins une diode et un support unique qui supporte le dissipateur dans les différents plans,
- le dissipateur unique comporte des moyens de déconnexion électrique des portions d'échange thermique entre elles.

L'invention concerne aussi un procédé de fabrication du dispositif de signalisation et/ou d'éclairage, tel que le procédé comporte une étape de formage du dissipateur thermique de sorte qu'au moins une saillie est formée par déformation plastique sur la surface du dissipateur au droit de l'embase de chaque diode associée de façon à former des moyens d'orientation de chaque diode.

Selon d'autres caractéristiques du procédé de fabrication :
- l'étape de formage du dissipateur thermique consiste à former au moins une saillie par déformation plastique sur la surface du dissipateur de façon à former des moyens de centrage de chaque diode,
- l'étape de formage du dissipateur thermique consiste à former au moins une saillie par déformation plastique sur la surface du dissipateur thermique de façon à former un bossage qui porte des moyens d'orientation et/ou de centrage de chaque diode associée,
- le procédé comporte une étape de découpage et de pliage du dissipateur thermique de sorte qu'au moins un crochet est formé, de façon à former des moyens de fixation du dissipateur sur la plaque à circuits imprimés,
- le procédé comporte une étape de poinçonnage du dissipateur thermique de sorte qu'au moins une ouverture est réalisée dans le dissipateur de façon à former des moyens de fixation du support et/ou de l'élément optique,
- le procédé comporte une étape d'insertion de chaque crochet dans une ouverture associée de la plaque à circuits imprimés de façon à fixer le dissipateur thermique sur la plaque à circuits imprimés,
- le procédé comporte une étape de soudage ou de brasage ou de collage de l'embase de chaque diode sur la portion d'échange thermique du dissipateur associé après avoir disposé chaque diode sur les moyens d'orientation du dissipateur et/ou positionné chaque diode par rapport au moyens de centrage,
- le procédé comporte une étape d'assemblage du support avec le dissipateur thermique qui consiste à introduire chaque pion de fixation du support dans une ouverture associée du dissipateur thermique,
- le procédé comporte une étape d'assemblage d'un élément optique avec le dissipateur thermique qui consiste à introduire chaque pion de fixation de l'élément optique dans une ouverture associée du dissipateur thermique.

D'autres caractéristiques et avantages de l'invention apparaîtront à la lecture de la description détaillée qui suit pour la compréhension de laquelle on se reportera aux dessins annexés dans lesquels :
- la figure 1 est une vue de face en coupe selon l'axe 1-1 des figures 2a ou 2b, illustrant une diode agencée sur un dissipateur thermique d'un composant de dissipation thermique selon les enseignements de l'invention ;
- la figure 2a est une vue de dessus de détail d'une portion d'échange thermique du dissipateur thermique dans un premier mode de réalisation du composant de la figure 1 ;
- la figure 2b est une vue de dessus de détail d'une portion d'échange thermique du dissipateur thermique dans un second mode de réalisation du composant de la figure 1 ;
- la figure 3 est une vue éclatée en perspective, illustrant un dispositif d'éclairage et/ou de signalisation selon un mode particulier de réalisation de l'invention et qui comporte un composant de dissipation thermique du genre représenté à la figure 1 ;
- la figure 4 est une vue de détail du dispositif de la figure 3 à plus grande échelle d'un pion de fixation d'un élément optique qui est logé dans une ouverture du dissipateur thermique de la figure 1 ;
- la figure 5 est une vue en perspective du dispositif d'éclairage et/ou de signalisation de la figure 3 ;
- la figure 6 est une vue schématique illustrant un procédé de fabrication par matriçage du dissipateur thermique de la figure 1 ;
- la figure 7 est une vue en perspective illustrant une variante de réalisation du dispositif d'éclairage et/ou de signalisation de la figure 3 ;
- la figure 8 est une vue schématique illustrant une variante de réalisation du dispositif d'éclairage et/ou de signalisation de la figure 3 ;
- la figure 9 est une vue similaire à celle de la figure 1, illustrant une variante de réalisation du dissipateur thermique.

Dans la description et les revendications, on utilisera à titre non limitatif les expressions telles que supérieur et inférieur en référence aux figures et définitions données dans la description et les orientations longitudinal, transversal, vertical en référence au trièdre L,V,T représenté aux figures.

De plus, les éléments identiques, similaires ou analogues seront désignés par les mêmes chiffres de référence.

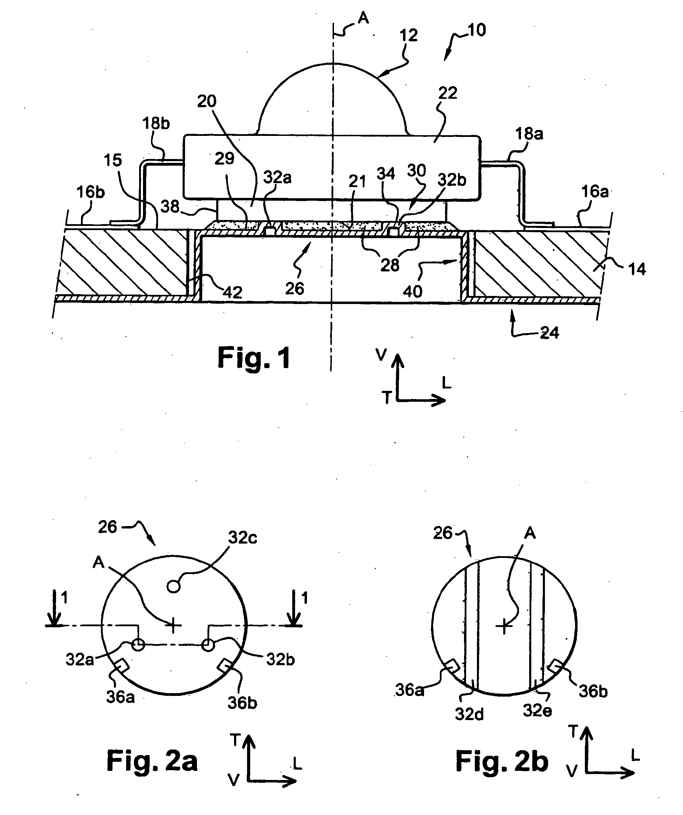

On a représenté à la figure 1 un composant 10 de dissipation thermique pour une diode 12 électroluminescente de puissance.

Le composant 10 de dissipation comporte une plaque 14 à circuits imprimés qui s'étend horizontalement. De façon connue, la plaque 14 à circuits imprimés est rigide et en matériau isolant électriquement, par exemple en époxy et tissu de verre.

La face supérieure 15 de la plaque 14 à circuits imprimés comporte deux pistes 16a, 16b conductrices d'électricité qui sont chacune raccordée électriquement à une patte 18a, 18b latérale d'alimentation électrique de la diode 12.

La diode 12, ou LED, comporte une embase 20 inférieure de dissipation thermique, aussi appelée "slug", qui est avantageusement en cuivre ou en alliage de cuivre. L'embase 20 de la diode 12 est ici de forme cylindrique d'axe A et comporte une face d'échange thermique 21 horizontale.

A titre non limitatif, l'embase 20 peut être par exemple de section hexagonale, ou circulaire.

La diode 12 est apte à produire un faisceau lumineux d'axe optique A vers le haut, selon une direction de référence, ici une direction perpendiculaire à l'embase 20 de la diode 12.

Le composant 10 de dissipation thermique comporte un dissipateur thermique 24, ou radiateur, qui s'étend globalement horizontalement au-dessous de la plaque 14 à circuits imprimés. Le dissipateur 24 présente ainsi un plan de référence.

Le dissipateur 24 comporte un bossage 40 qui s'étend verticalement vers le haut à travers un trou de passage 42 de la plaque 14 à circuits imprimés.

La partie supérieure du bossage 40 comporte une portion d'échange thermique 26 horizontale qui est en contact thermique avec l'embase 20 de la diode 12 pour évacuer la chaleur produite par la diode 12 lors de son fonctionnement.

Ainsi, le bossage 40 surélève la diode 12 de façon que les pattes 18a, 18b de la diode 12 sont aptes à être raccordées aux pistes 16a, 16b conductrices associées.

Le dissipateur 24 est en cuivre de faible épaisseur, de l'ordre d'un demi millimètre, de façon à obtenir un dissipateur thermique 24 "nerveux", c'est-à-dire un dissipateur 24 qui est apte à monter rapidement en température, pour dissiper rapidement la chaleur produite par la diode 12.

A titre non limitatif, le dissipateur 24 peut être en cuivre pur protégé par une couche de nickel ou d'étain ou il peut être en alliage de bronze et de béryllium par exemple.

L'utilisation du cuivre permet au dissipateur 24 d'atteindre une température stabilisée plus rapidement qu'avec, par exemple, de l'aluminium à épaisseur et dimensions égales.

On a représenté à la figure 2a une portion d'échange thermique 26 du dissipateur thermique 24 dans un premier mode de réalisation du composant 10.

Dans ce mode de réalisation, des moyens d'orientation 32a, 32b, 32c permettent de réduire le contact avec la surface 21 de l'embase 20 de la diode 12 sur des zones se réduisant idéalement en un point.

Les moyens d'orientation 32a, 32b, 32c de la diode 12 comportent trois plots 32a, 32b, 32c qui font saillie verticalement vers le haut, perpendiculairement à la portion d'échange thermique 26 du dissipateur 24.

Chaque plot 32a, 32b, 32c comporte une face supérieure 34 sur laquelle la face d'échange thermique 21 de l'embase 20 de la diode 12 est maintenue en contact. Les trois plots 32a, 32b, 32c sont agencés de manière régulière, délimitant un triangle équilatéral.

Selon des variantes, il est possible de disposer les plots 32a, 32b, 32c selon d'autres dessins ou en nombre différent.

Dans le mode de réalisation de la figure 2a, les faces supérieures 34 des plots 32a, 32b, 32c s'étendent dans un même plan horizontal qui est parallèle au plan de référence du dissipateur 24.

De cette manière, l'axe optique A de la diode 12 est orienté selon la direction de référence, perpendiculairement au plan de référence du dissipateur 24, parce que l'axe optique A de la diode 12 est perpendiculaire au plan de la face d'échange 21 de l'embase 20.

Toutefois, les faces supérieures 34 des plots 32a, 32b, 32c peuvent s'étendrent dans un plan oblique non horizontal de façon à orienter l'axe optique A de la diode 12 de manière oblique par rapport au plan de référence du dissipateur 24.

Ainsi, les moyens d'orientation 32a, 32b, 32c permettent, lors de la fabrication du dissipateur 24, de déterminer l'orientation relative de la direction de référence de chaque diode 12 à au moins un plan de référence du dissipateur 24.

A cette fin, la hauteur de chaque plot 32a, 32b, 32c est déterminée lors de sa formation relativement au plan de référence du dissipateur 24.

On a représenté à la figure 2b une portion d'échange thermique 26 du dissipateur thermique 24 dans un second mode de réalisation du composant 10.

Dans ce mode de réalisation, des moyens d'orientation 32d, 32e, permettent de réduire le contact avec la face d'échange thermique 21 de l'embase 20 de la diode 12 sur des zones se réduisant idéalement chacune en une ligne.

Dans ce mode de réalisation, des moyens d'orientation 32d, 32e de la diode 12 comportent deux nervures 32d, 32e parallèles qui font saillie verticalement vers le haut et qui comportent chacune une face horizontale supérieure sur laquelle la face d'échange thermique 21 de l'embase 20 de la diode 12 est apte à être maintenue en contact.

En se référent à nouveau à la figure 1, l'embase 20 de la diode 12 est maintenue ou solidarisée sur les plots 32a, 32b, 32c au moyen d'un apport de matière 28.

L'apport de matière 28, représenté par un nuage de points à la figure 1, est ici de la pâte à braser 28 qui est disposée entre la face d'échange thermique 21 de l'embase 20 de la diode 12 et la face supérieure 29 de la portion d'échange 26.

L'apport de matière 28 est apte à raccorder thermiquement la face d'échange thermique 21 de l'embase 20 de la diode 12 et la face supérieure 29 de la portion d'échange 26.

De plus, l'apport de matière 28 est de faible épaisseur, de l'ordre de quelques microns, avantageusement de l'ordre de dix à trente microns, de façon à former un joint thermique apte à conduire la chaleur entre l'embase 20 de la diode 12 et la portion d'échange thermique 26 du dissipateur 24, le diode 12 étant alors à la fois solidarisée à la portion d'échange thermique 26 et couplée thermiquement avec elle.

A titre non limitatif, l'apport de matière 28 peut être tout matériau du type visqueux qui est apte à fixer et/ou coller l'embase 20 de la diode 12 sur les plots 32a, 32b, 32c.

De même, l'apport de matière 28 peut être un agent de conduction thermique sans pouvoir de fixation, comme de la graisse, auquel cas la diode 12 est fixée par ses pattes de fixation 18a, 18b sur les pistes 16a, 16b de la plaque 14 à circuits imprimés.

Toutefois, l'apport de matière 28 est ici un alliage de pâte à braser comportant de l'étain, de l'argent et du cuivre, aussi connu sous la désignation Sn96 5Ag3 Cu0.5.

Dans un mode de réalisation représenté aux figures 2a et 2b, le dissipateur thermique 24 comporte des moyens de centrage 36a, 36b de la diode 12 par rapport au dissipateur thermique 24.

Dans ce mode particulier, deux butées 36a, 36b sont formées selon un axe vertical et perpendiculaire à la portion d'échange thermique 26 du dissipateur 24.

Les deux butées 36a, 36b, font saillies verticalement vers le haut. Les deux butées 36a, 36b sont agencées dans un même demi espace de la diode 12 de façon à venir contre le bord périphérique 38 de l'embase 20, lors de la dépose de la diode 12.

A cet effet, on notera que les deux butées 36a, 36b sont plus hautes que les plots 32a, 32b, 32c, selon une extension assurant une bonne stabilité de la diode 12 avant sa solidarisation au dissipateur 24 ainsi qu'il a été décrit plus haut.

Ainsi, la diode 12 est positionnée de façon précise dans les trois dimensions par rapport au dissipateur thermique 24.

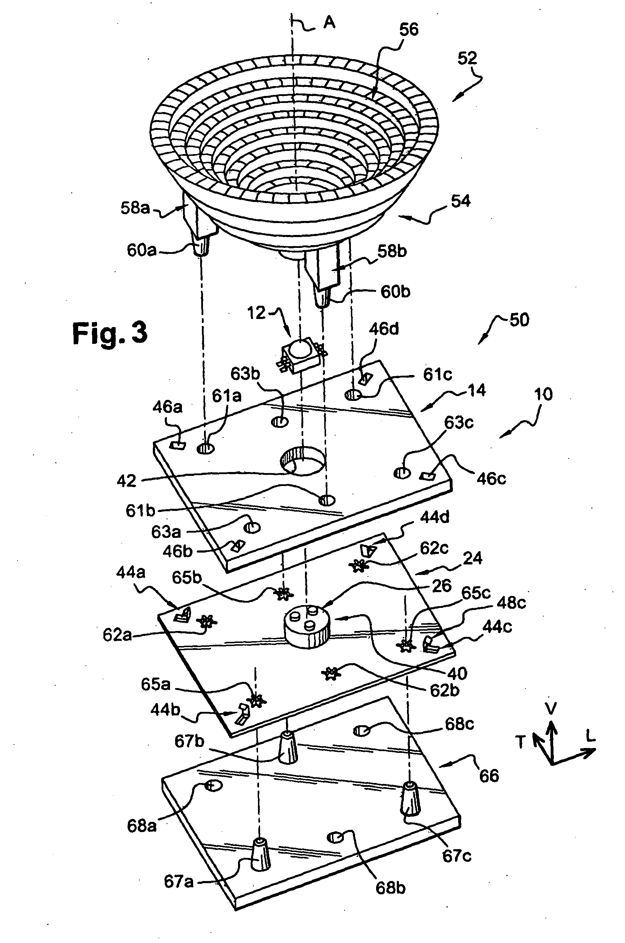

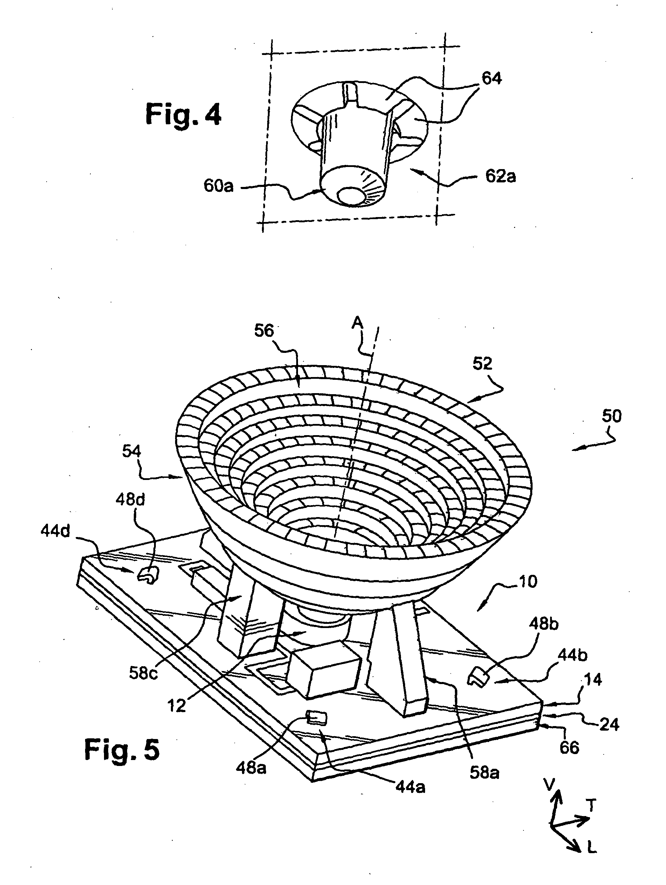

Comme on peut le voir aux figures 3 et 5, le dissipateur thermique 24 comporte quatre crochets 44a, 44b, 44c, 44d ou griffes, formant moyens de fixation relatifs du dissipateur 24 à la plaque à circuits imprimés 14.

Les quatre crochets 44a, 44b, 44c, 44d s'étendent globalement verticalement vers le haut depuis le dissipateur thermique 24, chacun à travers un trou 46a, 46b, 46c, 46d associé de la plaque 14 à circuits imprimés.

Chaque crochet 44a, 44b, 44c, 44d comporte à son extrémité libre une portion 48a, 48b, 48c, 48d de retour qui verrouille le dissipateur 24 contre la plaque 14 à circuits imprimés.

L'invention concerne aussi un dispositif d'éclairage et/ou de signalisation 50, qui est représenté aux figures 3 et 5, et qui comporte un composant 10 de dissipation thermique du type décrit précédemment.

Le dispositif d'éclairage et/ou de signalisation 50 comporte un élément optique 52. On entend par élément optique 52 une pièce ou un ensemble de pièces permettant d'agir sur le flux lumineux qui est produit par la diode 12, comme un filtre, une lentille et/ou un réflecteur.

L'élément optique 52 est ici un réflecteur 54 de lumière dans lequel est agencé une lentille de Fresnel 56.

De façon connue, la lentille de Fresnel 56 comporte une pluralité d'étages circulaires coaxiaux, formant globalement une section tronconique décroissante vers le bas.

L'élément optique 52 est agencé selon l'axe A de référence de la diode 12.

Le réflecteur 54 comporte trois pieds 58a, 58b, 58c qui sont en appui sur la face supérieure 15 de la plaque 14 à circuits imprimés. L'extrémité libre de chaque pied 58a, 58b, 58c comporte respectivement un pion 60a, 60b, 60c de fixation globalement tronconique qui s'étend verticalement vers le bas.

Chaque pion 60a, 60b, 60c de fixation est logé dans un trou de passage 61 a, 61b, 61 c de la plaque 14 à circuits imprimés et est fixé dans une ouverture 62a, 62b, 62c associée du dissipateur 24.

Comme on peut le voir en détail à la figure 4, chaque ouverture 62a, 62b, 62c est ménagée dans le dissipateur 24 et est caractérisée par une forme globalement circulaire, dont le pourtour intérieur présente une pluralité de languettes 64 de rétention. Chaque ouverture 62a, 62b, 62c constitue ainsi un élément connu par l'homme du métier sous le nom d'agripine (ou sous le vocable anglo-saxon « crimping »). A noter qu'une ouverture 62a, 62b, 62c ne présentant qu'une unique languette 64 de rétention constitue également une agripine.

Par exemple, les languettes 64 de rétention sont disposées sur la totalité du pourtour de chaque ouverture 62a, 62b, 62c. Chaque languette 64 de rétention est caractérisée par une base, directement rattachée au dissipateur 24, et par une extrémité libre qui est orientée vers la partie centrale de chaque ouverture 62a, 62b, 62c.

Ainsi, lors de l'étape d'introduction d'un des pions de fixation 60a, 60b, 60c dans l'ouverture 62a, 62b, 62c associée, chaque languette 64 de rétention peut légèrement se déformer dans le sens du mouvement d'introduction. Les extrémités libres de chaque languette 64 de rétention accompagnant alors le pion de fixation 60a, 60b, 60c associé dans son évolution.

La pluralité des languettes 64 de rétention de chaque ouverture 62a, 62b, 62c permet de maintenir au mieux le pion de fixation 60a, 60b, 60c associé. Le caractère ductile du matériau employé pour réaliser le dissipateur 24, et donc pour réaliser les languettes 64 de rétention, présente cet avantage supplémentaire de gêner un mouvement inverse au mouvement d'introduction du pion de fixation 60a, 60b, 60c dans l'ouverture 62a, 62b, 62c associée.

Dans le cas où le dissipateur 24 est en cuivre, son épaisseur est avantageusement comprise entre 0,4 et 0,8 millimètres d'épaisseur, de façon à pouvoir obtenir des agripines telles que décrites précédemment.

Avantageusement, le dispositif d'éclairage et/ou de signalisation 50 comporte un support 66 en plastique qui s'étend au-dessous du dissipateur 24, comme le montre les figures 3 et 5.

Le support 66 comporte une pluralité de pions de fixation 67a, 67b, 67c, ici au nombre de trois, qui sont globalement tronconique et qui s'étendent verticalement vers le haut. Chaque pion de fixation 67a, 67b, 67c est agencé dans une ouverture 65a, 65b, 65c associée du dissipateur 24. Chaque ouverture 65a, 65b, 65c est du type "agripine", telle que décrite précédemment.

Chaque pion de fixation 67a, 67b, 67c débouche dans un trou de passage 63a, 63b, 63c associé de la plaque 14 à circuits imprimés.

A titre indicatif, le support 66 comporte trois trous 68a, 68b, 68c de passage à travers chacun desquels débouche un des pions 60a, 60b, 60c de l'élément optique 52.

On va maintenant décrire le procédé de fabrication du dissipateur thermique 24.

Avantageusement, le bossage 40, les plots 32a, 32b, 32c formant moyens d'orientation de la diode 12 et les butées 36a, 36b formant moyens de centrage 36a, 36b de la diode 12 sont réalisés au cours d'une étape unique de formage par déformation plastique, par exemple par matriçage ou emboutissage.

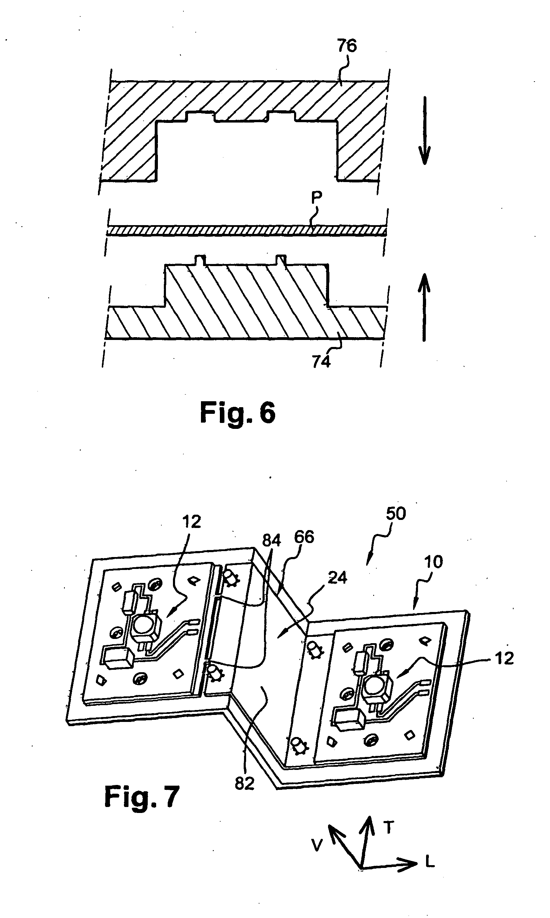

Comme on peut le voir à la figure 6, l'étape de formage est ici une opération de matriçage consistant à façonner une plaque P de cuivre, en la plaçant entre deux matrices 74, 76 et en lui faisant subir une ou plusieurs frappes, de manière à obtenir le dissipateur 24 forgé dans les dimensions et la forme souhaitées décrites précédemment.

Les ouvertures 62a, 62b, 62c et 65a, 65b, 65c, ou "agripines", du dissipateur 24, sont réalisées au cours d'une étape de poinçonnage du dissipateur thermique 24 au moyen d'un outil de poinçonnage.

Enfin, les quatre crochets 44a, 44b, 44c, 44d formant moyens de fixation sont réalisés au cours d'une étape de découpage et de pliage.

Selon un mode de fabrication préféré, l'étape de formage, qui consiste notamment à former les moyens de centrage 36a, 36b et d'orientation 32a, 32b, 32c, est réalisée à la suite des étapes de poinçonnage et de découpage et de pliage, de façon à ne pas détériorer lesdits moyens de centrage 36a, 36b et d'orientation 32a, 32b, 32c.

On va maintenant décrire le procédé de fabrication du composant 10 de dissipation thermique.

Une fois formé, le dissipateur 24 est fixé contre une face inférieure de la plaque 14 à circuits imprimés, de manière que les quatre crochets 44a, 44b, 44c, 44d de fixation verrouillent le dissipateur 24 sur la plaque 14 à circuits imprimés, comme le montre la figure 5.

Avantageusement, les portions 48a, 48b, 48c, 48d de retour des crochets 44a, 44b, 44c, 44d de fixation sont pliées sur la face supérieure de la plaque 14 à circuits imprimés, pour assurer un verrouillage sans jeu du dissipateur 24 sur la plaque 14.

On dispose à froid l'apport de matière 28, ici de la pâte à braser 28, sur la face supérieure 29 de la portion d'échange thermique 26.

On dépose l'embase 20 de la diode 12 contre les plots 32a, 32b, 32c et sur la pâte à braser 28 dont l'épaisseur est préalablement calibrée par une lame de calibrage de pâte.

Ensuite, l'embase 20 de la diode 12 est agencée sur les plots 32a, 32b, 32c d'orientation et est positionnée en butée contre les moyens de centrage 36a, 36b de la diode 12.

Ainsi, la pâte à braser 28 s'étale globalement sur toute la surface de l'embase 20 de la diode 12, hormis sur la surface qui est contact avec la surface supérieure 34 des moyens d'orientation 32a, 32b, 32c.

On dispose également de la pâte à braser 28 entre chacune des pattes 18a, 18b latérales d'alimentation électrique de la diode 12 et chacune des pistes 16a, 16b conductrices associées.

L'ensemble diode 12, plaque 14 à circuits imprimés et dissipateur 24 est passé au four à une température comprise entre 240°C et 260°C environ pendant une période de temps d'environ dix à trente secondes pour que la pâte à braser 28 entre en fusion et forme un joint de raccord entre les pièces avec lesquelles la pâte à braser 28 est agencée.

On va maintenant décrire le procédé de fabrication du dispositif d'éclairage et/ou de signalisation 50 selon l'invention.

On fixe le support 66 sur le composant 10 de dissipation thermique, en introduisant chaque pion 67a, 67b, 67c de fixation du support 66 dans l'ouverture 65a, 65b, 65c associée du dissipateur thermique 24.

De même, on fixe l'élément optique 52 par rapport au composant 10 de dissipation thermique en introduisant chaque pion 60a, 60b, 60c de fixation de l'élément optique 52 à travers les trous de passage 61a, 61b, 61c de la plaque 14 à circuits imprimés puis en introduisant chaque pion 60a, 60b, 60c dans l'ouverture 62a, 62b, 62c associée du dissipateur thermique 24.

Selon une variante de réalisation de l'invention, la plaque 14 à circuits imprimés peut être un film souple du type "flexboard", par exemple en matériau plastique, dont la résistance mécanique est telle que ladite plaque 14 à circuits imprimés est apte à être fixée sur le dissipateur 24, notamment au moyens des crochets 44a, 44b, 44c, 44d.

Aussi, la plaque 14 à circuits imprimés peut être "multicouche", c'est-à-dire que chacune de ses grandes faces comporte un réseau de pistes conductrices. Dans ce cas, la face du dissipateur 24 qui est en contact avec la plaque 14 est isolée électriquement.

Selon une autre variante de réalisation non représentée du composant 10 de dissipation thermique, le dissipateur thermique 24 comporte un bossage 40 ou une nervure sur lequel est disposé une pluralité de portions d'échange thermique 26 sur chacune desquelles est agencé une diode 12, dans l'hypothèse selon laquelle la mise en court circuit électrique des embases 20 des diodes 12 n'est pas un problème.

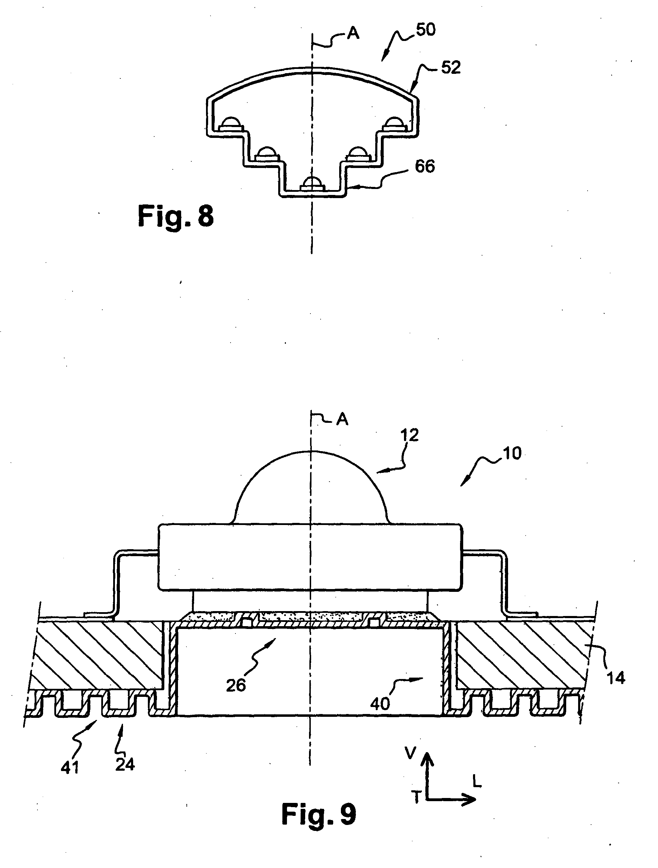

Selon une autre variante, le dissipateur thermique 24 peut comporter une pluralité de créneaux 41 ou ailettes 41 qui sont agencées en vis-à-vis de la plaque 14 à circuits imprimés et qui sont formés d'une alternance de faces verticales et horizontales, comme on peut le voir à la figure 9.

Ainsi, les créneaux ou ailettes 41 permettent de rigidifier le dissipateur 24, d'augmenter la surface d'échange thermique du dissipateur 24 au voisinage de la portion d'échange thermique 26 du dissipateur 24 et de limiter le contact avec la plaque 14 à circuits imprimés pour transmettre moins de chaleur à la plaque 14 à circuits imprimés.

Selon une autre variante non représentée, le dissipateur thermique 24 du composant 10 de dissipation thermique peut s'étendre latéralement et globalement verticalement de part et d'autre de la plaque 14 à circuits imprimés, de façon à augmenter la surface d'échange thermique du dissipateur 24.

Selon une variante de réalisation représentée à la figure 8, le composant 10 de dissipation thermique du dispositif d'éclairage et/ou de signalisation 50 comporte une pluralité de portions d'échange thermique 26. Les portions d'échange thermique 26 sont disposées symétriquement dans des plans globalement horizontaux et globalement parallèles entre eux, de part et d'autre d'un plan médian de symétrie. Chaque portion d'échange thermique 26 comporte au moins une diode 12.

A titre non limitatif, les plans dans lesquels sont disposées les portions d'échange thermique 26 peuvent être sensiblement inclinés les uns par rapport aux autres de sorte que les axes optiques des diodes 12 convergent ou divergent pour former un faisceau lumineux. De même, le dispositif 50 n'est pas forcément symétrique.

Selon cette variante, le dispositif d'éclairage et/ou de signalisation 50 comporte un élément optique 52 qui est agencé dans le plan médian de symétrie selon l'axe optique A global.

De plus, les portions d'échange thermique 26 sont formées dans un dissipateur 24 unique.

A cet effet, les portions consécutives du dissipateur 24 comportant les portions d'échanges thermiques 26 sont raccordées entre elles par une portion de raccord 82, représentée à la figure 7.

Chaque portion de raccord 82 du dissipateur 24 comporte des moyens de déconnexion électrique des portions d'échange thermique 26 entre elles.

Les moyens de déconnexion comportent ici une paire de pattes 84 qui sont sectionnées au cours de la fabrication du dispositif d'éclairage et/ou de signalisation 50, de façon à déconnecter électriquement les portions d'échange thermique 26 et les embases 20 des diodes 12.

Enfin, le dispositif d'éclairage et/ou de signalisation 50 comporte un support 66 unique en forme d'un escalier, qui s'étend contre le dissipateur 24 pour le supporter.

Le composant 10 de dissipation thermique selon l'invention permet d'orienter et de positionner l'axe optique A de chaque diode 12 selon le plan de référence du dissipateur 24 de façon précise.

En effet, le procédé de fabrication des plots 32a, 32b, 32c d'orientation permet d'obtenir des cotes et des tolérances précises.

De plus, l'ajout de matière 28 permet de maintenir le dissipateur 24 contre l'embase 20 de la diode 12, sans influencer l'orientation et le positionnement de la diode 12.

En outre, l'épaisseur de l'ajout de matière 28 est bien maîtrisée, puisque son épaisseur est égale à la hauteur des plots 32a, 32b, 32c. L'épaisseur de la portion d'échange thermique 26 du dissipateur 24 est bien maîtrisée également, ce qui permet de maîtriser le coefficient de conduction thermique du dissipateur thermique 24 ainsi que sa "nervosité" thermique.

Enfin, les ouvertures 62a, 62b, 62c et 65a, 65b, 65c, ou "agripines", du dissipateur thermique 24 permettent de positionner et de fixer l'élément optique 52 et le support 66 par rapport au dissipateur 24, de façon précise.

## Revendications

1. Composant (10) de dissipation thermique pour dispositif d'éclairage et/ou de signalisation (50) de véhicule du type comportant :
- une plaque (14) à circuits imprimés isolante électriquement comportant au moins deux pistes (16a, 16b) conductrices d'électricité,
- au moins une diode (12) électroluminescente qui comporte une embase (20) de dissipation thermique et une paire de pattes (18a, 18b) de connexion électrique, chaque patte (18a, 18b) de connexion devant être raccordée électriquement à une piste (16a, 16b) conductrice de la plaque (14) à circuits imprimés,
- un dissipateur thermique (24) qui s'étend en vis-à-vis de la plaque (14) à circuits imprimés,
**caractérisé en ce que** le dissipateur thermique (24) comporte au moins une portion d'échange thermique (26) apte à être couplée à une face d'échange thermique (21) de l'embase (20) d'au moins une diode (12) associée, et **en ce que** ladite portion d'échange thermique (26) du dissipateur thermique (24) comporte des moyens d'orientation (32a, 32b, 32c) d'au moins une diode (12) associée qui font saillie au niveau de la portion d'échange thermique (26) du dissipateur (24), la face d'échange thermique (21) de l'embase (20) de chaque diode (12) étant destinée à être posée sur lesdits moyens d'orientation (32a, 32b, 32c), notamment de manière qu'une direction de référence de chaque diode (12) soit orientée par rapport à un plan de référence du dissipateur (24).

2. Composant (10) de dissipation thermique selon la revendication 1, **caractérisé en ce que** lesdits moyens d'orientation (32a, 32b, 32c) font saillie substantiellement perpendiculairement à la portion d'échange thermique (26) du dissipateur (24).

3. Composant (10) de dissipation thermique selon la revendication 1 ou 2, **caractérisé en ce que** les moyens d'orientation comportent une pluralité de plots (32a, 32b, 32c) qui font saillie perpendiculairement à la portion d'échange thermique (26) selon des dimensions permettant de déterminer la direction de référence de chaque diode (12).

4. Composant (10) de dissipation thermique selon la revendication 2, **caractérisé en ce que** les moyens d'orientation comportent au moins deux nervures qui font saillie perpendiculairement à la portion d'échange thermique (26).

5. Composant (10) de dissipation thermique selon l'une quelconque des revendications précédentes, **caractérisé en ce que** le dissipateur thermique (24) comporte un bossage (40) sur lequel est agencé la portion d'échange thermique (26) du dissipateur (24).

6. Composant (10) de dissipation thermique selon l'une quelconque des revendications précédentes, **caractérisé en ce qu'**il comporte un apport de matière (28) qui est disposé entre la portion d'échange thermique (26) du dissipateur thermique (24) et la face d'échange thermique (21) de l'embase (20) de chaque diode (12) associée, afin de fixer la portion d'échange thermique (26) avec l'embase (20) de chaque diode (12) et/ou de former un joint thermique entre la portion d'échange thermique (26) et l'embase (20) de chaque diode (12).

7. Composant (10) de dissipation thermique selon l'une quelconque des revendications précédentes, **caractérisé en ce que** le dissipateur thermique (24) comporte des moyens de centrage (36a, 36b) de chaque diode (12) associée par rapport au plan de référence du dissipateur (24).

8. Composant (10) de dissipation thermique selon l'une quelconque des revendications précédentes, **caractérisé en ce que** le dissipateur thermique (24) comporte des moyens de fixation (44a, 44b, 44c, 44d) avec la plaque (14) à circuits imprimés.

9. Composant (10) de dissipation thermique selon l'une quelconque des revendications précédentes, **caractérisé en ce que** le dissipateur thermique (24) est en matériau qui est apte à subir une déformation plastique, comme un matériau ductile.

10. Composant (10) de dissipation thermique selon l'une quelconque des revendications précédentes, **caractérisé en ce que** le dissipateur thermique (24) est en cuivre ou en alliage de cuivre d'une épaisseur déterminée en fonction de caractéristiques de conduction thermique déterminées.

11. Composant (10) de dissipation thermique selon l'une quelconque des revendications précédentes, **caractérisé en ce que** la plaque (14) à circuits imprimés comporte au moins un trou (42) à travers lequel s'étend au moins une diode (12) et/ou la portion d'échange thermique (26) du dissipateur (24).

12. Composant (10) de dissipation thermique selon l'une quelconque des revendications précédentes, **caractérisé en ce que** la plaque (14) à circuits imprimés est souple et est apte à être maintenue sur le dissipateur (24) par des moyens de fixation (44a, 44b, 44c, 44d).

13. Dispositif d'éclairage et/ou de signalisation (50) du type comportant :
- au moins un composant (10) de dissipation thermique selon l'une quelconque des revendications 1 à 12, et
- un support (66) qui est fixé sur le composant (10) de dissipation thermique au moyen de pions (67a, 67b, 67c) de fixation, les pions (67a, 67b, 67c) de fixation étant fixés dans des ouvertures (65a, 65b, 65c) associées du dissipateur thermique (24).

14. Dispositif d'éclairage et/ou de signalisation (50) selon la revendication 13, **caractérisé en ce qu'**il comporte un élément optique (52) comme un filtre, et/ou une lentille et/ou un réflecteur qui est disposé sur la plaque (14) à circuits imprimés et qui est fixé sur le dissipateur thermique (24) au moyen de pions (60a, 60b, 60c) de fixation, les pions (60a, 60b, 60c) de fixation traversant la plaque (14) à circuits imprimés et étant fixés dans des ouvertures (62a, 62b, 62c) associées du dissipateur thermique (24).

15. Dispositif d'éclairage et/ou de signalisation (50) selon la revendication 13 ou 14, **caractérisé en ce que** le composant (10) comporte :
- un dissipateur (24) unique qui comporte une pluralité de portions d'échange thermique (26), les portions d'échange thermique (26) étant chacune agencées dans un plan différent, chaque portion d'échange thermique (26) comportant au moins une diode (12),
- un support (66) unique qui supporte le dissipateur (24) dans les différents plans.

16. Dispositif d'éclairage et/ou de signalisation (50) selon la revendication précédente, **caractérisé en ce que** le dissipateur (24) unique comporte des moyens de déconnexion (84) électrique des portions d'échange thermique (26) entre elles.

17. Procédé de fabrication d'un dispositif d'éclairage et/ou de signalisation (50), le dispositif étant du genre selon l'une quelconque des revendications 13 à 16, **caractérisé en ce que** le procédé comporte une étape de formage du dissipateur thermique (24) de sorte qu'au moins une saillie (32a, 32b, 32c) est formée par déformation plastique sur la surface du dissipateur (24) au droit de l'embase (20) de chaque diode (12) associée de façon à former des moyens d'orientation de chaque diode (12).

18. Procédé de fabrication d'un dispositif d'éclairage et/ou de signalisation (50) selon la revendication précédente, **caractérisé en ce que** l'étape de formage du dissipateur thermique (24) consiste à former au moins une saillie (36a, 36b) par déformation plastique sur la surface du dissipateur (24) de façon à former des moyens de centrage (36a, 36b) de chaque diode (12).

19. Procédé de fabrication selon les revendications 17 ou 18, **caractérisé en ce que** l'étape de formage du dissipateur thermique (24) consiste à former au moins une saillie (40) par déformation plastique sur la surface du dissipateur thermique (24) de façon à former un bossage (40) qui porte des moyens d'orientation (32a, 32b, 32c) et/ou de centrage (36a, 36b) de chaque diode (12) associée.

20. Procédé de fabrication selon l'une quelconque des revendications 17 à 19, **caractérisé en ce que** le procédé comporte une étape de découpage et de pliage du dissipateur thermique (24) de sorte qu'au moins un crochet (44a, 44b, 44c, 44d) est formé, de façon à former des moyens de fixation (44a, 44b, 44c, 44d) du dissipateur (24) sur la plaque (14) à circuits imprimés.

21. Procédé de fabrication selon l'une quelconque des revendications 17 à 20, **caractérisé en ce que** le procédé comporte une étape de poinçonnage du dissipateur thermique (24) de sorte qu'au moins une ouverture (62a, 62b, 62c, 65a, 65b, 65c) est réalisée dans le dissipateur (24) de façon à former des moyens de fixation du support (66) et/ou de l'élément optique (52).

22. Procédé de fabrication selon la revendication 20, **caractérisé en ce que** le procédé comporte une étape d'insertion de chaque crochet (44a, 44b, 44c, 44d) dans une ouverture (46a, 46b, 46c, 46d) associée de la plaque (14) à circuits imprimés de façon à fixer le dissipateur thermique (24) sur la plaque (14) à circuits imprimés.

23. Procédé de fabrication selon l'une quelconque des revendications 17 à 22, **caractérisé en ce que** le procédé comporte une étape de soudage ou de brasage ou de collage de l'embase (20) de chaque diode (12) sur la portion d'échange thermique (26) du dissipateur (24) associé après avoir disposé chaque diode (12) sur les moyens d'orientation (32a, 32b, 32c) du dissipateur (24) et/ou positionné chaque diode (12) par rapport au moyens de centrage (36a, 36b).

24. Procédé de fabrication selon la revendication 20, **caractérisé en ce que** le procédé comporte une étape d'assemblage du support (66) avec le dissipateur thermique (24) qui consiste à introduire chaque pion (67a, 67b, 67c) de fixation du support (66) dans une ouverture (65a, 65b, 65c) associée du dissipateur thermique (24).

25. Procédé de fabrication selon la revendication 20, **caractérisé en ce que** le procédé comporte une étape d'assemblage d'un élément optique (52) avec le dissipateur thermique (24) qui consiste à introduire chaque pion (60a, 60b, 60c) de fixation de l'élément optique (52) dans une ouverture (62a, 62b, 62c) associée du dissipateur thermique (24).

## Claims

1. Thermal dissipation component (10) for a lighting and/or signalling device (50) for a vehicle, of the type comprising:
- an electrically insulating plate (14) with printed circuits, comprising at least two tracks (16a, 16b) which conduct electricity;
- at least one LED (12) which comprises a thermal dissipation base (20) and a pair of electrical connection lugs (18a, 18b), each connection lug (18a, 18b) having to be connected electrically to a conductive track (16a, 16b) of the plate (14) with printed circuits; and
- a thermal dissipater (24) which extends opposite the plate (14) with printed circuits,
**characterised in that** the thermal dissipater (24) comprises at least one heat-exchange portion (26) which can be coupled to a heat-exchange surface (21) of the base (20) of at least one associated diode (12), and **in that** the said heat-exchange portion (26) of the thermal dissipater (24) comprises means (32a, 32b, 32c) for orientation of at least one associated diode (12) which project at the level of the heat-exchange portion (26) of the dissipater (24), the heat-exchange surface (21) of the base (20) of each diode (12) being designed to be placed on the said orientation means (32a, 32b, 32c) in particular such that a reference direction of each diode (12) is oriented relative to a reference plane of the dissipater (24).

2. Thermal dissipation component (10) according to claim 1, **characterised in that** the said orientation means (32a, 32b, 32c) project substantially perpendicularly to the heat-exchange portion (26) of the dissipater (24).

3. Thermal dissipation component (10) according to claim 1 or 2, **characterised in that** the orientation means comprise a plurality of lugs (32a, 32b, 32c) which project perpendicularly to the heat-exchange portion (26), according to dimensions which make it possible to determine the reference direction of each diode (12).

4. Thermal dissipation component (10) according to claim 2, **characterised in that** the orientation means comprise at least two ribs which project perpendicularly to the heat-exchange portion (26).

5. Thermal dissipation component (10) according to any one of the preceding claims, **characterised in that** the thermal dissipater (24) comprises a boss (40) on which the heat-exchange portion (26) of the dissipater (24) is arranged.

6. Thermal dissipation component (10) according to any one of the preceding claims, **characterised in that** it comprises added material (28) which is disposed between the heat-exchange portion (26) of the thermal dissipater (24) and the heat-exchange surface (21) of the base (20) of each associated diode (12), in order to secure the heat-exchange portion (26) to the base (20) of each diode (12), and/or to form a heat seal between the heat-exchange portion (26) and the base (20) of each diode (12).

7. Thermal dissipation component (10) according to any one of the preceding claims, **characterised in that** the thermal dissipater (24) comprises means (36a, 36b) for centring of each associated diode (12) relative to the reference plane of the dissipater (24).

8. Thermal dissipation component (10) according to any one of the preceding claims, **characterised in that** the thermal dissipater (24) comprises means (44a, 44b, 44c, 44d) for securing to the plate (14) with printed circuits.

9. Thermal dissipation component (10) according to any one of the preceding claims, **characterised in that** the thermal dissipater (24) is made of a material which can undergo plastic deformation, such as a ductile material.

10. Thermal dissipation component (10) according to any one of the preceding claims, **characterised in that** the thermal dissipater (24) is made of copper or copper alloy, with a thickness which is determined in accordance with predetermined thermal conduction characteristics.

11. Thermal dissipation component (10) according to any one of the preceding claims, **characterised in that** the plate (14) with printed circuits comprises at least one hole (42) through which there extends at least one diode (12) and/or the heat-exchange portion (26) of the dissipater (24).

12. Thermal dissipation component (10) according to any one of the preceding claims, **characterised in that** the plate (14) with printed circuits is flexible, and can be maintained on the dissipater (24) by securing means (44a, 44b, 44c, 44d).

13. Lighting and/or signalling device (50) of the type comprising:
- at least one thermal dissipation component (10) according to any one of claims 1 to 12; and
- a support (66) which is secured to the thermal dissipation component (10) by means of securing pins (67a, 67b, 67c), the securing pins (67a, 67b, 67c) being secured in associated openings (65a, 65b, 65c) in the thermal dissipater (24).

14. Lighting and/or signalling device (50) according to claim 13, **characterised in that** it comprises an optical element (52) as a filter, and/or a lens and/or a reflector which is disposed on the plate (14) with printed circuits, and is secured to the thermal dissipater (24) by means of securing pins (60a, 60b, 60c), the securing pins (60a, 60b, 60c) passing through the plate (14) with printed circuits, and being secured in associated openings (62a, 62b, 62c) in the thermal dissipater (24).

15. Lighting and/or signalling device (50) according to claim 13 or 14, **characterised in that** the component (10) comprises:
- a single dissipater (24) which comprises a plurality of heat-exchange portions (26), the heat-exchange portions (26) each being arranged on a different plane, each heat-exchange portion (26) comprising at least one diode (12); and
- a single support (66) which supports the dissipater (24) on the different planes.

16. Lighting and/or signalling device (50) according to the preceding claim, **characterised in that** the single dissipater (24) comprises means (84) for electrical disconnection of the heat-exchange portions (26) from one another.

17. Method for production of a lighting and/or signalling device (50), the device being of the type according to any one of claims 13 to 16, **characterised in that** the method comprises a step of forming the thermal dissipater (24) such that at least one projection (32a, 32b, 32c) is formed by plastic deformation on the surface of the dissipater (24) at right-angles to the base (20) of each associated diode (12), such as to form means for orientation of each diode (12).

18. Method for production of a lighting and/or signalling device (50) according to the preceding claim, **characterised in that** the step of forming the thermal dissipater (24) consists of forming at least one projection (36a, 36b) by plastic deformation on the surface of the dissipater (24), such as to form centring means (36a, 36b) for each diode (12).

19. Production method according to claims 17 or 18, **characterised in that** the step of forming the thermal dissipater (24) consists of forming at least one projection (40) by plastic deformation on the surface of the thermal dissipater (24) such as to form a boss (40) which bears means for orientation (32a, 32b, 32c) and/or centring (36a, 36b) of each associated diode (12).

20. Production method according to any one of claims 17 to 19, **characterised in that** the method comprises a step of cutting and folding the thermal dissipater (24) so that at least one hook (44a, 44b, 44c, 44d) is formed, such as to form means (44a, 44b, 44c, 44d) for securing the dissipater (24) to the plate (14) with printed circuits.

21. Production method according to any one of claims 17 to 20, **characterised in that** the method comprises a step of punching the thermal dissipater (24), so that at least one opening (62a, 62b, 62c, 65a, 65b, 65c) is formed in the dissipater (24), such as to form means for securing the support (66) and/or the optical element (52).

22. Production method according to claim 20, **characterised in that** the method comprises a step of insertion of each hook (44a, 44b, 44c, 44d) in an associated opening (46a, 46b, 46c, 46d) in the plate (14) with printed circuits, such as to secure the thermal dissipater (24) to the plate (14) with printed circuits.

23. Production method according to any one of claims 17 to 22, **characterised in that** the method comprises a step of soldering or brazing or gluing the base (20) of each diode (12) onto the heat-exchange portion (26) of the associated dissipater (24), after having placed each diode (12) on the means (32a, 32b, 32c) for orientation of the dissipater (24), and/or positioned each diode (12) relative to the centring means (36a, 36b).

24. Production method according to claim 20, **characterised in that** the method comprises a step of assembly of the support (66) with the thermal dissipater (24), which consists of introducing each pin (67a, 67b, 67c) for securing of the support (66) in an associated opening (65a, 65b, 65c) in the thermal dissipater (24).

25. Production method according to claim 20, **characterised in that** the method comprises a step of assembly of an optical element (52) with the thermal dissipater (24), which consists of introducing each pin (60a, 60b, 60c) for securing of the optical element (52) in an associated opening (62a, 62b, 62c) in the thermal dissipater (24).

## Patentansprüche

1. Wärmeableitendes Bauelement (10) für eine Fahrzeugbeleuchtungs- und/oder Fahrzeugsignalgebungsvorrichtung (50) des Typs mit:
- einer elektrisch isolierenden Leiterplatte (14) mit wenigstens zwei Stromleiterbahnen (16a, 16b),
- wenigstens einer Leuchtdiode (12), die einen wärmeableitenden Sockel (20) und ein Paar Anschlussklemmen (18a, 18b) umfasst, wobei jede Anschlussklemme (18a, 18b) mit einer Leiterbahn (16a, 16b) der Leiterplatte (14) elektrisch verbunden sein muss,
- einem Wärmeableiter (24), der gegenüber der Leiterplatte verläuft,
**dadurch gekennzeichnet, dass** der Wärmeableiter (24) wenigstens ein Wärmeübergangsstück (26) aufweist, das an eine Wärmeübergangsfläche (21) des Sockels (20) wenigstens einer zugeordneten Diode (12) gekoppelt zu werden vermag, und dass das Wärmeübergangsstück (26) des Wärmeableiters (24) Mittel (32a, 32b, 32c) zum Ausrichten wenigstens einer zugeordneten Diode (12) umfasst, die in Höhe des Wärmeübergangsstücks (26) des Wärmeableiters (24) vorstehen, wobei die Wärmeübergangsfläche (21) des Sockels (20) jeder Diode (12) dazu bestimmt ist, auf den Ausrichtmitteln (32a, 32b, 32c) insbesondere so angebracht zu sein, dass eine Bezugsrichtung jeder Diode (12) bezüglich einer Bezugsebene des Wärmeableiters (24) ausgerichtet ist.

2. Wärmeableitendes Bauelement (10) nach Anspruch 1,
**dadurch gekennzeichnet, dass** die Ausrichtmittel (32a, 32b, 32c) im Wesentlichen lotrecht zum Wärmeübergangsstück (26) des Wärmeableiters (24) vorstehen.

3. Wärmeableitendes Bauelement (10) nach Anspruch 1 oder 2,
**dadurch gekennzeichnet, dass** die Ausrichtmittel eine Vielzahl von Stiften (32a, 32b, 32c) umfassen, die lotrecht zum Wärmeübergangsstück (26) in Größen vorstehen, die die Bezugsrichtung jeder Diode (12) zu bestimmen erlauben.

4. Wärmeableitendes Bauelement (10) nach Anspruch 2,
**dadurch gekennzeichnet, dass** die Ausrichtmittel wenigstens zwei Rippen aufweisen, die lotrecht zum Wärmeübergangsstück (26) vorstehen.

5. Wärmeableitendes Bauelement (10) nach einem der vorhergehenden Ansprüche,
**dadurch gekennzeichnet, dass** der Wärmeableiter (24) eine Erhebung (40) aufweist, auf der das Wärmeübergangsstück (26) des Wärmeableiters (24) angeordnet ist.

6. Wärmeableitendes Bauelement (10) nach einem der vorhergehenden Ansprüche,
**dadurch gekennzeichnet, dass** es ein Auftragsmaterial (28) umfasst, das zwischen dem Wärmeübergangsstück (26) des Wärmeableiters (24) und der Wärmeübergangsfläche (21) des Sockels (20) jeder zugeordneten Diode (12) angeordnet ist, um das Wärmeübergangsstück (26) und den Sockel (20) jeder Diode (12) aneinander zu befestigen und/oder eine wärmeleitende Verbindungsstelle zwischen dem Wärmeübergangsstück (26) und dem Sockel (20) jeder Diode (12) zu bilden.

7. Wärmeableitendes Bauelement (10) nach einem der vorhergehenden Ansprüche,
**dadurch gekennzeichnet, dass** der Wärmeableiter (24) Mittel (36a, 36b) zum Zentrieren jeder zugeordneten Diode (12) bezüglich der Bezugsebene des Wärmeableiters (24) umfasst.

8. Wärmeableitendes Bauelement (10) nach einem der vorhergehenden Ansprüche,
**dadurch gekennzeichnet, dass** der Wärmeableiter (24) Mittel (44a, 44b, 44c, 44d) zum Befestigen an der Leiterplatte (14) umfasst.

9. Wärmeableitendes Bauelement (10) nach einem der vorhergehenden Ansprüche,
**dadurch gekennzeichnet, dass** der Wärmeableiter (24) aus einem Material besteht, das plastisch verformt zu werden vermag, wie etwa ein duktiles Material.

10. Wärmeableitendes Bauelement (10) nach einem der vorhergehenden Ansprüche,
**dadurch gekennzeichnet, dass** der Wärmeableiter (24) aus Kupfer oder einer Kupferlegierung mit einer in Abhängigkeit von ermittelten wärmeleitenden Merkmalen bestimmten Dicke besteht.

11. Wärmeableitendes Bauelement (10) nach einem der vorhergehenden Ansprüche,
**dadurch gekennzeichnet, dass** die Leiterplatte (14) wenigstens ein Loch (42) umfasst, durch das sich eine Diode (12) und/oder das Wärmeübergangsstück (26) des Wärmeableiters (24) erstreckt.

12. Wärmeableitendes Bauelement (10) nach einem der vorhergehenden Ansprüche,
**dadurch gekennzeichnet, dass** die Leiterplatte (14) biegsam ist und auf dem Wärmeableiter (24) durch Befestigungsmittel (44a, 44b, 44c, 44d) gehalten zu werden vermag.

13. Beleuchtungs- und/oder Signalgebungsvorrichtung (50) des Typs mit:
- wenigstens einem wärmeableitenden Bauelement (10) nach einem der Ansprüche 1 bis 12, und
- einem Träger (66), der auf dem wärmeableitenden Bauelement (10) mittels Befestigungsstiften (67a, 67b, 67c) befestigt ist, wobei die Befestigungsstifte (67a, 67b, 67c) in zugeordneten Öffnungen (65a, 65b, 65c) des Wärmeableiters (24) befestigt sind.

14. Beleuchtungs- und/oder Signalgebungsvorrichtung (50) nach Anspruch 13,
**dadurch gekennzeichnet, dass** sie ein optisches Element (52) wie einen Filter und/oder eine Linse und/oder einen Reflektor umfasst, das auf der Leiterplatte (14) angeordnet ist und das auf dem Wärmeableiter (24) mittels Befestigungsstiften (60a, 60b, 60c) befestigt ist, wobei die Befestigungsstifte (60a, 60b, 60c) die Leiterplatte (14) durchqueren und in den zugeordneten Öffnungen (62a, 62b, 62c) des Wärmeableiters (24) befestigt sind.

15. Beleuchtungs- und/oder Signalgebungsvorrichtung (50) nach Anspruch 13 oder 14,
**dadurch gekennzeichnet, dass** das Bauelement (10) umfasst:
- einen einzigen Wärmeableiter (24), der eine Vielzahl von Wärmeübergangsstücken (26) umfasst, wobei die Wärmeübergangsstücke (26) jeweils in einer unterschiedlichen Ebene angeordnet sind, wobei jedes Wärmeübergangsstück (26) wenigstens eine Diode (12) aufweist,
- einen einzigen Träger (66), der den Wärmeableiter (24) in den verschiedenen Ebenen hält.

16. Beleuchtungs- und/oder Signalgebungsvorrichtung (50) nach dem vorhergehenden Anspruch,
**dadurch gekennzeichnet, dass** der einzige Wärmeableiter (24) Mittel (84) zum Trennen einer elektrischen Verbindung der Wärmeübergangsstücke (26) untereinander umfasst.

17. Verfahren zur Fertigung einer Beleuchtungs- und/oder Signalgebungsvorrichtung (50), wobei die Vorrichtung von der Art nach einem der Ansprüche 13 bis 16 ist,
**dadurch gekennzeichnet, dass** das Verfahren einen Schritt zum Formen des Wärmeableiters (24) umfasst, so dass wenigstens ein Vorsprung (32a, 32b, 32c) durch plastische Verformung auf der Oberfläche des Wärmeableiters (24) rechtwinklig zum Sockel (20) jeder zugeordneten Diode (12) gebildet wird, um die Ausrichtmittel jeder Diode (12) zu bilden.

18. Verfahren zur Fertigung einer Beleuchtungs- und/oder Signalgebungsvorrichtung (50) nach dem vorhergehenden Anspruch,
**dadurch gekennzeichnet, dass** der Schritt zum Formen des Wärmeableiters (24) darin besteht, wenigstens einen Vorsprung (36a, 36b) durch plastische Verformung auf der Oberfläche des Wärmeableiters (24) zu bilden, um Mittel (36a, 36b) zum Zentrieren jeder Diode (12) zu bilden.

19. Fertigungsverfahren nach den Ansprüchen 17 oder 18,
**dadurch gekennzeichnet, dass** der Schritt zum Formen des Wärmeableiters (24) darin besteht, wenigstens einen Vorsprung (40) durch plastische Verformung auf der Oberfläche des Wärmeableiters (24) zu bilden, um eine Erhebung (40) zu bilden, die Mittel zum Ausrichten (32a, 32b, 32c) und/oder Zentrieren (36a, 36b) jeder zugeordneten Diode (12) trägt.

20. Fertigungsverfahren nach einem der Ansprüche 17 bis 19,
**dadurch gekennzeichnet, dass** das Verfahren einen Schritt zum Schneiden und Biegen des Wärmeableiters (24) umfasst, so dass wenigstens ein Haken (44a, 44b, 44c, 44d) geformt wird, um Mittel (44a, 44b, 44c, 44d) zum Befestigen des Wärmeableiters (24) auf der Leiterplatte (14) zu bilden.

21. Fertigungsverfahren nach einem der Ansprüche 17 bis 20,
**dadurch gekennzeichnet, dass** das Verfahren einen Schritt zum Lochen des Wärmeableiters (24) umfasst, so dass wenigstens eine Öffnung (62a, 62b, 62c, 65a, 65b, 65c) in dem Wärmeableiter (24) entsteht, um Mittel zum Befestigen des Trägers (66) und/oder des optischen Elements (52) zu bilden.

22. Fertigungsverfahren nach Anspruch 20,
**dadurch gekennzeichnet, dass** das Verfahren einen Schritt zum Einsetzen jedes Hakens (44a, 44b, 44c, 44d) in eine zugeordnete Öffnung (46a, 46b, 46c, 46d) der Leiterplatte (14) umfasst, um den Wärmeableiter (24) auf der Leiterplatte (14) zu befestigen.

23. Fertigungsverfahren nach einem der Ansprüche 17 bis 22,
**dadurch gekennzeichnet, dass** das Verfahren einen Schritt zum Schweißen oder Löten oder Kleben des Sockels (20) jeder Diode (12) auf das Wärmeübergangsstück (26) des zugeordneten Wärmeableiters (24) umfasst, nachdem jede Diode (12) auf den Ausrichtmitteln (32a, 32b, 32c) des Wärmeableiters (24) angeordnet und/oder jede Diode (12) bezüglich der Zentriermittel (36a, 36b) positioniert worden ist.

24. Fertigungsverfahren nach Anspruch 20,
**dadurch gekennzeichnet, dass** das Verfahren einen Schritt zum Verbinden des Trägers (66) mit dem Wärmeableiter (24) umfasst, der darin besteht, jeden Stift (67a, 67b, 67c) zur Befestigung des Trägers (66) in eine zugeordnete Öffnung (65a, 65b, 65c) des Wärmeableiters (24) einzuführen.

25. Fertigungsverfahren nach Anspruch 20,
**dadurch gekennzeichnet, dass** das Verfahren einen Schritt zum Verbinden eines optischen Elements (52) mit dem Wärmeableiter (24) umfasst, der darin besteht, jeden Stift (60a, 60b, 60c) zur Befestigung des optischen Elements (52) in eine zugeordnete Öffnung (62a, 62b, 62c) des Wärmeableiters (24) einzuführen.
